Europäisches Patentamt

European Patent Office

Office européen des brevets

(11) Publication number: **0 269 235**
**A2**

## (12) EUROPEAN PATENT APPLICATION

(21) Application number: 87309098.9

(22) Date of filing: 14.10.87

(51) Int. Cl.4: **G11C 17/00**

(30) Priority: 21.11.86 JP 277980/86

(43) Date of publication of application:
01.06.88 Bulletin 88/22

(84) Designated Contracting States:
DE FR GB

(71) Applicant: **Kabushiki Kaisha Toshiba**
**72 Horikawa-cho Saiwai-ku**
**Kawasaki-shi Kanagawa-ken(JP)**

(72) Inventor: **Naruke, Yasuo c/o Patent Division**
**Toshiba Corporation Principal Office**
**1-1, Shibaura 1-Chome Minato-ku Tokyo(JP)**

(74) Representative: **Sturt, Clifford Mark et al**
**MARKS & CLERK 57-60 Lincoln's Inn Fields**
**London WC2A 3LS(GB)**

(54) **High density high speed read only semiconductor memory device.**

(57) This invention provides a read only semiconductor memory device comprising, a semiconductor substrate (40), a data line (41) arranged in the substrate (40) for transferring data from the memory device, memory cell transistor means arranged in the substrate (40) for simultaneously increasing the operating speed and packing density of the device, including a common source (33) and a common drain (34), and a plurality of transistors (39), each including a gate electrode (31), and source, drain, and channel regions in the substrate (40), connected in parallel relation between the common source (33) and the common drain (34), one of the common source (33) and the common drain (34) being coupled to the data line (41).

FIG.3.

Xerox Copy Centre

## High density high speed read only seminconductor memory device

This invention relates to a seminconductor memory device. In particular, it relates to ROM (read-only memory).

The type of semiconductor ROM memory in which each cell is constituted by a single MOS transistor is widely used, since it is well adapted to producing large-capacity memories. The two main types are described below. They are distinguished by their memory cell configurations.

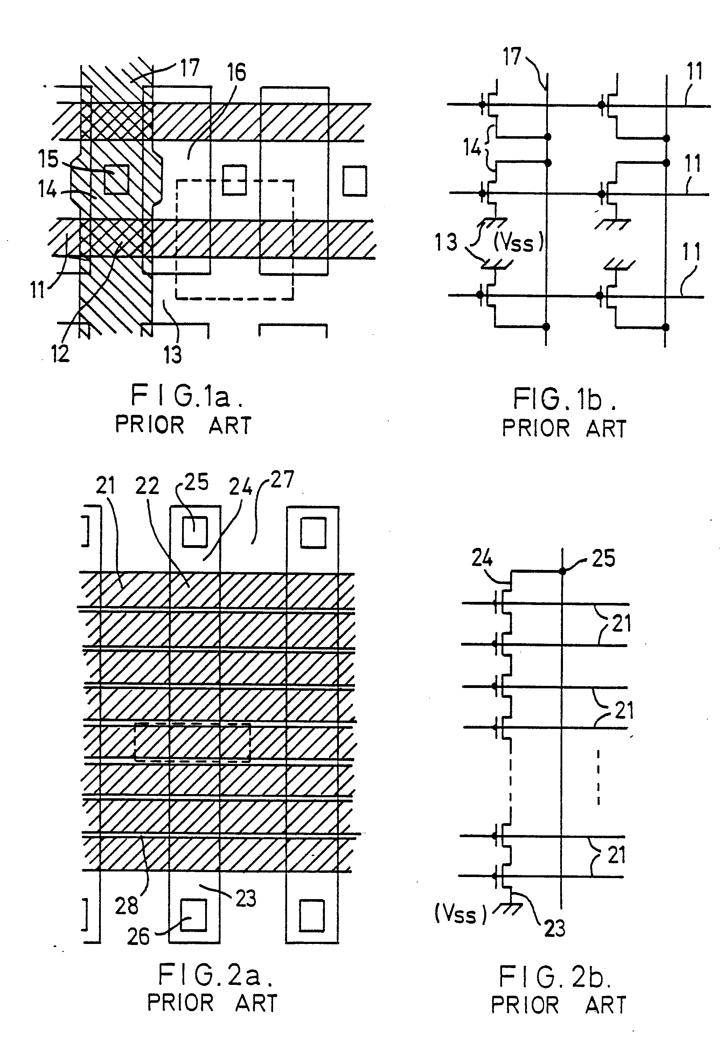

One type is the NOR type. In this type, as shown in Fig. 1a, transistor regions are mutually isolated by surrounding them with an insulating layer. In Fig. 1, reference numeral 11 designates a gate electrode (polysilicon), 12 represents a channel region, 13 denotes a source region, 14 designates a drain region, 15 represents a contact region, and 16 is an element isolating region. The data lines 17 (aluminium) connected to the transistors of the memory cells are disposed in the directions above gate electrode 11, intersect it at right angles, and pass through contact 15. An equivalent circuit diagram of Fig, 1a is shown in Fig. 1b with the same reference numerals as those of Fig. 1a.

A further type is called the NAND type. In this type, as shown in Fig. 2a, a plurality of gate electrode wires are arranged adjacent to each other. Channel regions are formed at right angles to these. A single memory cell is constituted by the channel region at the point of intersection with a single gate electrode. In Fig. 2a, reference numeral 21 designates a gate electrode, 22 represents a channel region, 23 denotes a source region, 24 designates a drain region, 25 and 26 are contact regions, 27 denotes an element isolating region, and 28 is an insulating film. An equivalent circuit diagram of Fig. 2a is shown in Fig. 2b, with the same reference numerals as those of Fig. 2a.

Comparing the memory cell areas (portions enclosed by the dotted lines) of the above two types, the NAND type has no contact holes and so is smaller, enabling the degree of circuit integration to be increased. However, in the NAND type, the channel length is long because a large number of gate electrodes are arranged next to each other, so the mutual conductance of the transistor series circuits is fairly small. This means that the operating speed is lower than it is with the NOR type. Thus, from the point of view of the demand for increased operating speed and density of circuit integration, the conventional NOR type and NAND type both have advantages and shortcomings. As a result, these requirements cannot be met simultaneously.

An object of this invention is to provide a semiconductor memory device which can combine excellent speed of operation, which is characteristic of the NOR type, with a high density of circuit integration, which is characteristic of the NAND type.

This invention provides a read only semiconductor memory device comprising, a semiconductor substate, a data line arranged in the substrate for transferring data from the memory device, memory cell transistor means arranged in the substrate for simultaneously increasing the operating speed and packing density of the device, including a common source and a common drain, and a plurality of transistors, each including a gate electrode, and source, drain, and channel regions in the substrate, connected in parallel relation between the common source and the common drain, one of the common source and the common drain being coupled to the data line.

Embodiments of the invention will now be described by way of example only and with reference to the accompanying drawings, in which:

Fig. 1a is a plan view of the pattern of a conventional NOR type memory device,

Fig. 1b is an equivalent circuit diagram of Fig. 1a,

Fig. 2a is a plan view of the pattern of a conventional NAND type memory device,

Fig. 2b is an equivalent circuit diagram of Fig. 2a,

Fig. 3 is a plan view of the pattern of an embodiment of this invention,

Fig. 4 and Fig. 5 are partial cross-sectional views of Fig. 3,

Fig. 6 is an equivalent circuit diagram of Fig. 3,

Fig. 7a is a plan view of the pattern of a further embodiment of this invention,

Fig. 7b is an equivalent circuit diagram of Fig. 7a,

Fig. 8 and Fig. 9 are cross-sectional views of alternative embodiments of this invention.

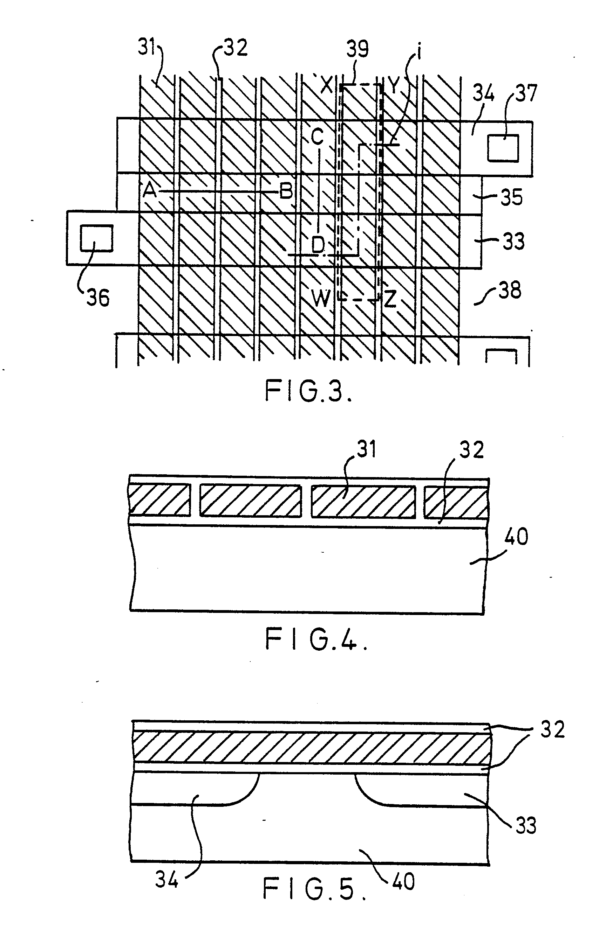

The embodiment shown in plan view in Fig. 3 will now be described; with reference also to Fig. 4 which is a cross-sectional view along the line A-B of Fig. 3, and with further reference to Fig. 5 which is a cross-sectional view along the line C-D of Fig. 3. As shown in these figures of the drawings, gate electrode wiring 31 (polysilicon) are mutually insulated by thin insulating films 32 made, for example, of $SiO_2$ of thickness 400 Angstrom ($4 \times 10^{-8}$m) on a semiconductor substrate 40. Source regions 33 and drain regions 34 are formed at right angles to gate wirings 31, with channel regions 35 between these regions 33 and 34. Source and drain contact regions 36 and 37 are made at the end portions of source regions 33 and drain regions 34. These regions 33, 34 and 35 are surrounded by element isolating region 38 made, for example, of a thick SiO$_2$ layer, to electrically isolate them from other regions. Therefore, a single cell region 39 is constituted by an area shown by rectangle XYZW.

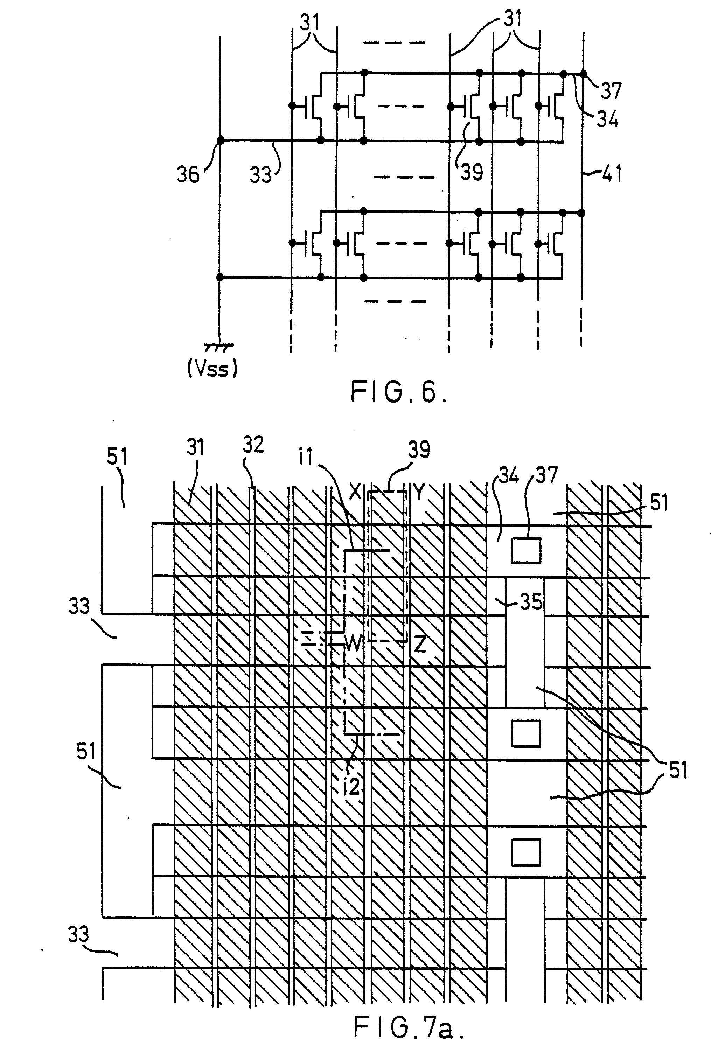

Fig. 6 shows the equivalent circuit to Fig. 3. The data lines 41 of Fig. 6 are not shown in Fig. 3. Current flows between source 33 and drain 34 through the single transistor of the cell by the route "i" shown in Fig. 3, i.e. the same as in the conventional NOR type. That is, as shown in Fig. 6, a single memory cell transistor 39 is constituted between data line 41 and the ground electrode, and the circuit is the same as that of the NOR type of Fig. 1b, so it can operate at the same high speed. However, the element isolation regions 16, Fig. 1a, between the cells in the transverse direction are absent from the arrangement shown in Fig. 3. Also, it will be readily apparent that the same high density of circuit integration can be obtained using the arrangement of Fig. 3 as with the conventional NAND type device. Furthermore, with the NAND type of Fig. 2a, only about ten gate electrodes 21 can be provided between source 23 and drain 24 due to conductance limitations. Since the configuration shown in Fig. 3 is of the NOR type, about 30 gate electrodes 31 can be provided between contacts 36 and 37. This also facilitates the attainment of higher densities of circuit integration.

Data writing is performed by, for example, altering the threshold voltage of the transistor, as in Fig. 1a during maunfacture of the device. Data lines 41 of Fig. 6 may be of a multi-layer construction using, for example, aluminium.

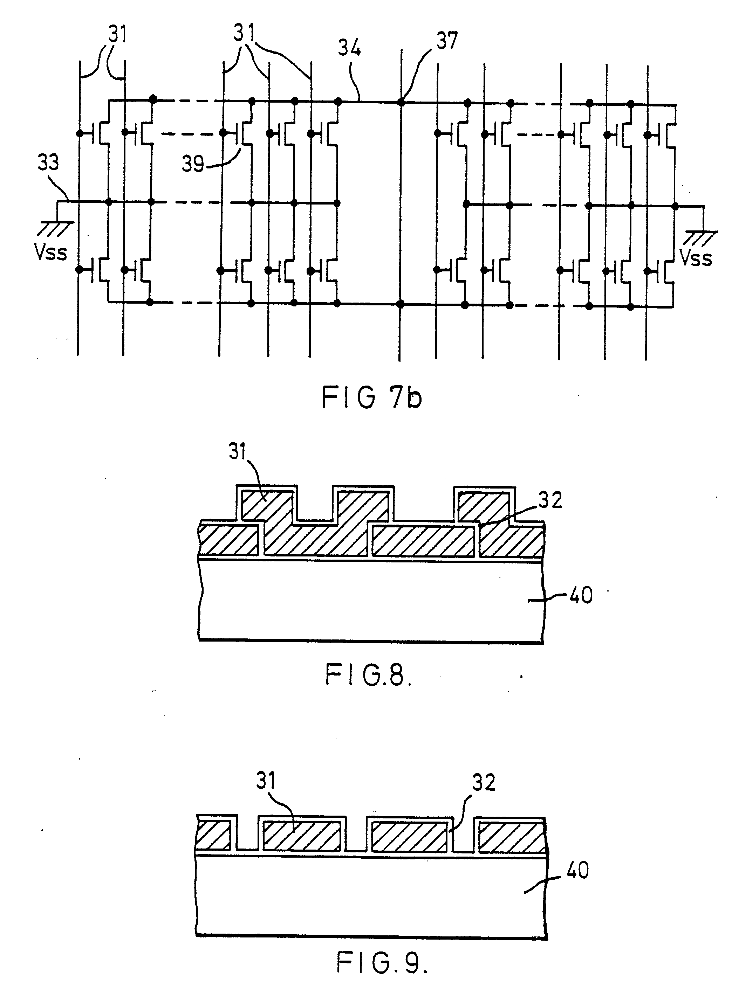

A further embodiment of this invention is shown in Fig. 7a. The embodiment of Fig. 3 is a case in which a single cell row has its own source region 33 and drain region 34. In the configuration shown in Fig. 7a, two cell rows share a single source region 33, making possible a further reduction in cell area. In Fig. 7a, reference numeral 51 designates an element isolating region, "i$_1$" represents the current route of the upper row of cells, and "i$_2$" denotes the current route of the lower row of cells. Locations indicated by the same reference numerals as in Fig. 3 correspond to those of Fig. 3 and further description thereof will be omitted. An equivalent circuit diagram of Fig. 7a, is shown in Fig. 7b with the same reference numerals as those of Fig. 7a. The plurality of transistors is divided into multiple groups, Each group includes at least two transistors. The multiple groups are connected in common to one of the common source 33 and common drain 34 as shown in Fig. 7b.

Fig. 8 and Fig. 9 correspond to Fig. 4, and are cross-sectional views of alternatibe embodiments of this invention. In the embodiment of Fig. 8, the gate electrodes partially overlap. In the embodiment of Fig. 9, the gate electrodes are separated.

As described above, with this invention, it is possible to eliminate the element isolating region on both sides of the channels, and the contact holes from the memory cell construction of the conventional NOR type; by making the gate electrodes intersect the source and drain regions at right angles, i.e. by arranging them next to each other in the direction of movement of the carriers (current flow) through the source and drain regions. Furthermore, the fact that the circuit also corresponds to that of the NOR type makes possible the provision of a semiconductor device which has higher density of circuit integration, with higher operating speed than conventional devices.

As will be readily apparent to those skilled in the art, various modifications and variations can be made to the described embodiments without departing from the scope of the invention.

## Claims

1. A read only semiconductor memory device comprising:
a semiconductor substrate (40);
a data line (41) arranged in the substrate (40) for transferring data from the memory device; and
memory cell transistor means (39) characterised in that the memory cell transistor means (39) are arranged in the substrate (40) for simultaneously increasing the operating speed and packing density of the device, including a common source (33) and a common drain (34), and a plurality of transistors (39), each including a gate electrode (31), and source, drain, and channel regions in the substrate (40), connected in parallel relation between the common source (33) and the common drain (34), one of the common source (33) and the common drain (34) being coupled to the data line (41).

2. A device as claimed in claim 1, further characterised in that the gate electrode (31) of the plurality of transistors (3a) are parallel to one another, and each gate electrode (31) overlaps a portion of the source, drain and channel regions (33, 34, 35) of the corresponding transistors (39).

3. A device as claimed in claim 2, further characterised in that the transistor means includes a first insulating film (32) between the gate electrodes (31) and the channel, source and drain regions (33, 34, 35) of the plurality of transistors (39).

4. A device as claimed in claim 3, further characterised in that the transistor means also includes a second insulating film (32) between the gate electrodes (31) of adjacent ones of the plurality of transistors (39).

5. A device as claimed in claim 4, further characterised in that the source and drain (33, 34) of each of the plurality of transistors (39) are parallel to one another, the space between each source (33) and corresponding drain (34) comprising the channel region (35) of the transistor (39).

6. A device as claimed in claim 1, further characterised in that the plurality of transistors (39) includes multiple groups, each group including at least two transistors (39) and the multiple groups being connected in common to one of the common source (33) and common drain (34).

0 269 235

FIG.1a.
PRIOR ART

FIG.1b.
PRIOR ART

FIG.2a.
PRIOR ART

FIG.2b.
PRIOR ART

Neu eingereicht / Newly filed
Nouvellement déposé

FIG.3.

FIG.4.

FIG.5.

FIG. 6.

FIG. 7a.

FIG 7b

FIG.8.

FIG.9.